# EUROPEAN PATENT SPECIFICATION

(11) **EP 1 006 089 B1**
(45) Date of publication and mention of the grant of the patent: **12.07.2006**
(21) Application number: 99124876.6
(22) Date of filing: 23.11.1993
(51) Int. Cl.: C03C 13/04, G02B 6/10, C30B 33/00

(54) **Infrared crystalline optical fibre**
Kristalline optische Infrarotfaser
Fibre optique crystalline infrarouge

(43) Date of publication of application: 07.06.2000
(62) Divisional of application: 93118812.2
(73) Proprietor: CeramOptec GmbH, 53121 Bonn (DE)
(72) Inventor: Nabatov, Alexey, 109017 Moscow (RU); Kuzin, Eugeny, 125057 Moscow (RU); Artjushenko, Vjacheslav, Dr., 117607 Moscow (RU); Neuberger, Wolfgang, Dr., Labuan (MY)
(74) Representative: Altenburg, Udo

(56) References cited:
- DE-A- 3 101 998
- DE-A- 3 118 361
- US-A- 4 171 400
- US-A- 4 955 689
- PATENT ABSTRACTS OF JAPAN vol. 8, no. 248, 14 November 1984 (1984-11-14) -& JP 59 121003 A (ASAHI GLASS CO. LTD.), 12 July 1984 (1984-07-12)
- DATABASE WPI Section Ch, Week 27 Derwent Publications Ltd., London, GB; Class L03, AN 85-163344 XP002135008 -& JP 60 095404 A (ALOKA CO. LTD. ET AL.), 28 May 1985 (1985-05-28)

## Description

### BACKGROUND OF THE INVENTION

### 1. Field of Invention

The present invention relates to a silver halide crystalline fiber capable of transmitting infrared light. A more specifically, the invention infrared fibers are of technical interest for the transmission fo low power radiation signals from the environment, such as heat radiation to infrared tectors. They are of further interest in remote infrared spectroscopy and in the transmission of laser energy from CO₂ and CO lasers in particular. it involves such products which relate to improved AgClₓBr₁₋ₓ fibers (where x is 0 to 1.0).

### 2. Information Disclosure Statement

Silver halide fibers consisting of silver chloride (AgCl), silver bromide (AgBr), and their solid solutions (AgClₓBr₁₋ₓ) show promising properties for the transmission of middle infrared radiation. The fibers can either be bare core fibers, with gas functioning as the lower refractive index, total reflecting medium or polymer coated fibers or core/clad fibers where the cladding contains more AgCl for total internal reflection. These are described in United States Patent Numbers 4,253,731; 4,391,141; 4,504,298 and 4,552,434 and considerable improvements have been reported over time .

JP 59 121 003 A discloses an infrared fiber comprising AgCl and/or AgBr as an essential component and one of Pb and Cd elements to it or them. DE 31 01 998 A discloses an infrared optical fiber comprising a core consisting mainly of a halide to which a small amount of a supplementary other halide is added. DE 31 18 361 A discloses an infrared optical fiber which is manufactured by hot extruding of an alkali halide, silver halide or thallium halide crystal containing an earth alkali metal.

Nevertheless, there are some drawbacks in present silver halide crystalline fibers. One basic disadvantage of both bare core and step-index core/clad silver halide fibers is their tendency to deteriorate optically and mechanically probably due to recrystallization of the grain structure, phase separation and silver colloids formation as well as absorption and diffusion of extrinsic impurities.

Transmission and elasticity have been observed to decrease remarkably when present state-of-the-art fibers are bent repeatedly. This is a result of defect formation linked to the plastic deformation of the granular structure of the fibers. Present core/clad fibers frequently show intenneshing between the core and the clad material during their extrusion and, as a result, bad transmission. This defect arises due to inhomogeneous deformation during the conventional extrusion process. Further, fibers produced by alternative manufacturing methods such as multiple step-deformation by drawing the fiber through a row of dies as in, for example, United States Patents 4,381,141; 4,504,298 and 4,552,434, show defects such as microvoids and microcracks. It is assumed that these scattering defects result from the stretching stress applied in these manufacturing methods. The core/cladding boundary also shows defects if the process of successive rolling by grooved rolls is applied as suggested in some of the above prior art, probably due to the non-symmetric deformation mechanism. Additionally, trace contamination by lubricants or other extrinsic impurities is generally observed when multiple deformation methods are employed and these methods are more complicated and less productive than the conventional extrusion process.

### SUMMARY OF THE INVENTION

The present invention is directed to a silver halide optical fiber having decreased and stabilized optical losses and a higher elasticity of fibers.

This object is achieved by an optical fiber as defined in independent claim 1. Further preferred embodiments are set forth in the dependent claims 2 to 6.

### BRIEF DESCRIPTION OF THE DRAWINGS

The present invention is more fully understood when the instant specification is taken in conjunction with the drawings which are appended hereto, wherein:
Figure 1 shows a side cut view of a conventional extrusion processing equipment with the process in progress;
Figure 2 shows the resulting cross-section for a step-index type infrared crystalline fiber using the method of the prior art shown in Figure 1;
Figure 3 shows a cut side view of equipment for the extrusion in accordance with the process of producing a fiber of this invention with the method in progress;
Figure 4 shows a related cross-section of step-index fiber being produced by the method shown in Figure 3;
Figure 5 shows a preferred starting preform geometry for the laminar flow of extrusion in the process;
Figure 6 shows a cross-section of a preform with more details and being successively deformed at is periphery, consisting of a crystalline core and a crystalline cladding layer, a layer of polymer lubricant and a protective polymer or metal coating;
Figures 7a and 7b show a cross sectional cut of the fiber texture after extrusion of a predeformed core/clad preform, and a side cut view of that fiber; and,
Figure 8 shows a side cut view of a method arrangement for hydraulic extrusion in progress.

### DETAILED DESCRIPTION OF THE INVENTION

One object of the present invention is to provide an infrared light transmitting crystalline fiber having good and stable elasticity and a stable, low level of optical losses.

The fiber should possess a grain structure reacting favorable to multiple bending of the fibers. At the same time, the current shortcomings of core/clad intermeshing and microcracks/microvoids as well as surface contamination should be avoided.

The present invention achieves these objectives and overcomes the deficiencies of conventional techniques by stabilizing the composition of the main silver halide components by suitable dopants, by a pre extrusion treatment of the preform to form a strengthened profile of texture elongated along the preform axis, and by maintaining laminar flow conditions during the extrusion process by applying the extrusion pressure to the prepared preform in a direction opposite to the fiber flow.

We have found that photodegradation can be remarkably reduced by partially replacing halide anions by iodine and/or partially replacing silver cations by any alkali metals or by double valent cations. It is assumed that the homogenous distribution of the above listed elements in the fiber material creates additional barriers for the sliding and recrystallization effect in polycrystalline fibers and restricts the silver ion diffusion. This self-diffusion of interstitial silver ions determines the formation of silver colloids, that absorb the transmitted radiation.

Metal compounds suitable for doping are MY, type compound wherein M is a metal selected from Li, Na, K, Rb, Cs, or they are MeY₂ type where Me is selected from Mg, Ca, Sr, Ba, Cd, Pb or Hg, and Y is Cl, Br or I.

The expected effect of AgI crystallographic structure transition during the cooling of this crystal after its growth from the melt was surprisingly suppressed by limiting the content of AgI to less then 5% of the AgCl-AgBr matrix.

It was also determined that the concentration of double valent cations (Hg, Cd, Pb, etc.) needs to be restricted to less than 0.001% probably due to the substantial physical difference between them and the host cations of the lattice matrix.

The positive effect of the doping of the silver halide crystals on the transmission stability of the fibers can be observed with any chosen fiber structure (for examples, core only with gas as lower index surrounding, core with polymer cladding, core/clad fiber with silver halide core and lower refractive index silver halide compositions, cladding or graded index silver halide fiber).

It was observed that the grain structure in the finished fiber can be influenced by procreating the preform used for the fiber extrusion. If the preform is carefully deformed by exerting pressure to its lateral surface by preextrusion or by other methods with a low extent of deformation (<2) a texture with elongated grains is achieved. The texture is finer at the outside of the deformed preform while larger crystalline grains are prevailing at the inner core area. We have observed that fibers extruded from above described preforms exhibit similar texture and show improved transmission and stability. It is assumed that the fiber with a texture of superfine (0.01 to 0.2 µm) ellipsoidally shaped crystalline grains, elongated along the fiber axis and decreased in size in the peripherical fiber layers, deforms more elastically and with less defect formation when multiple bending of the fiber occurs, than a fiber with conventional, round shaped grain structure. Furtheron, the essentially longitudinal directed radiation rays pass over fewer grain boundaries and defects, which may further explain the enhanced transmission properties.

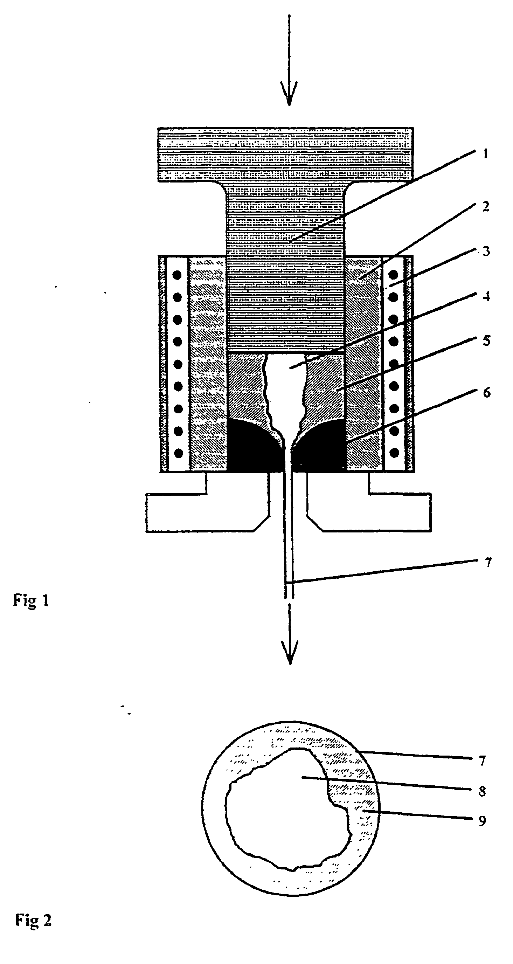

Referring now to Figure 1, a conventional prior art extrusion process is shown for a step-index type preform. This involves applying pressure with a plunger 1 and heat with heater 3 in high pressure chamber 2 to the crystalline preform comprising preform core 4 and cladding preform 5 to force the material in the direction of the applied force and to afterwards deform it through the orifice of a die 6 to obtain a fiber 7 with the desired diameter.

Figure 2 shows a cut cross section of fiber 7 from the method shown in Figure 1. It is observed, unfortunately, that the resulting fiber 7 shows pronounced deformations of the geometry of core 8 and clad 9 and shows intermeshing of core 8 and clad 9 materials. This rough core-cladding interface frequently causes high scattering losses in the fiber.

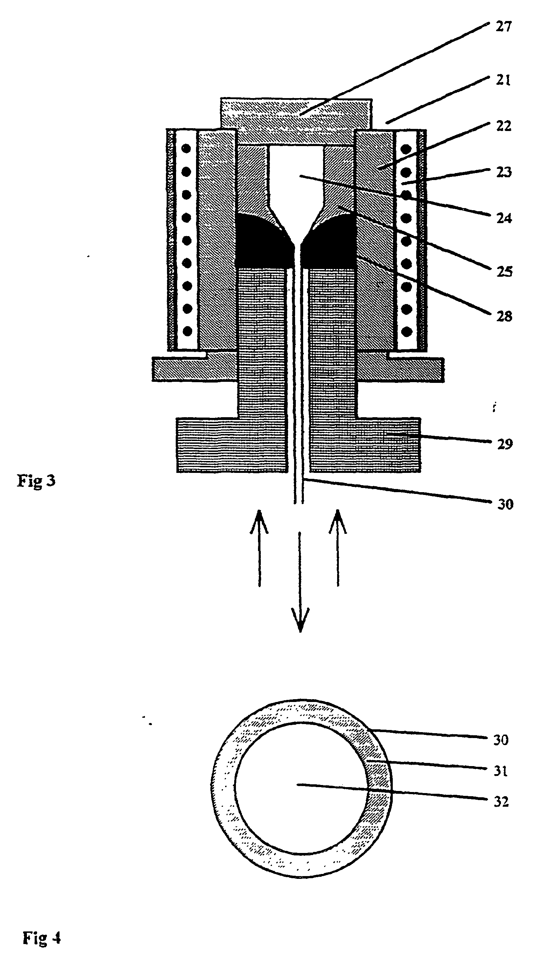

We attributed this shortcoming of the extrusion process to the friction of the material on the cylindrical chamber surface and to the related turbulences in the material flow. We have found, however, that by inversing the plunger movement (movement of the plunger in a direction opposite to the fiber movement) the problem can be essentially overcome and the fiber geometry remarkably improved. Thus, Figure 3 shows one method with apparatus 21.

In Figure 3, high pressure chamber 22, includes heater 23, core preform 24, and cladding preform 25. However, here, plunger 29 is below the preforms and moves upwardly, i.e. against the flow. Cap 27 holds the preforms in place and, as plunger 29 moves die 28 upwardly, fiber 30 is extruded downwardly therefrom.

Figure 4 shows a cross-sectional cut of fiber 30 from the Figure 3 process, wherein clad 31 and core 32 have a smooth, consistent interface with a relatively consistent clad thickness and core shape.

The main advantage of this method is probably the fixed position of a preform in the chamber which eliminates the friction at the lateral surface of the preform and, therefore, also eliminates the release of friction energy. The inhomogeneous deformation of complex step-index or gradient-index preforms due to friction-caused turbulence is practically inhomogeneous. The intermeshing between core and cladding layers is remarkably reduced.

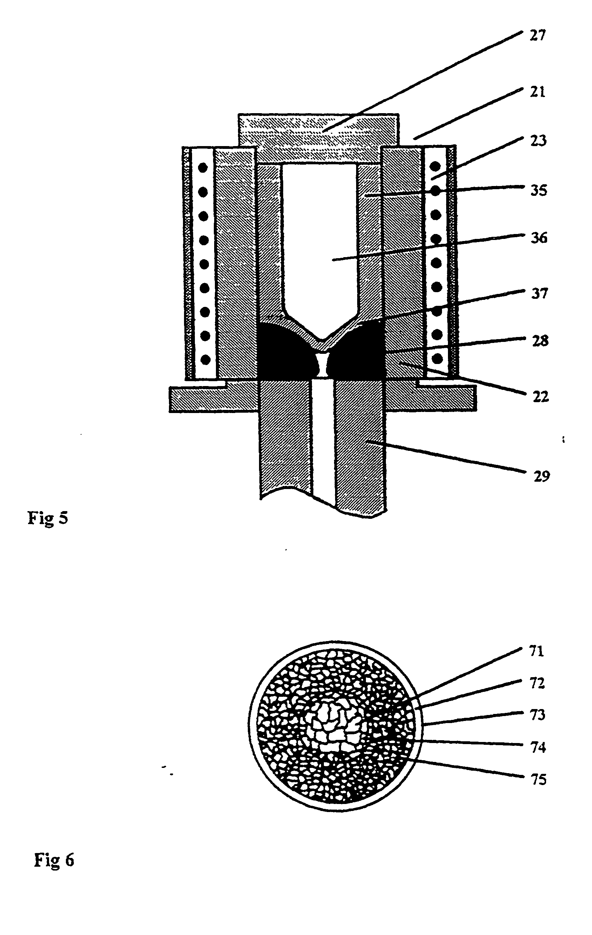

But even with the above described extrusion process, some residual irregularities for the starting stage of the extrusion may be observed. Figure 5 shows a further advance. Here, the same equipment as shown in Figure 3 is used, with like parts identically numbered. However, to reach the laminar flow geometry faster, additional cladding material 35 can be inserted not only at the side but also below the cylindrical core preform 36, as shown as base 37.

Further, by keeping the plunger diameter marginally smaller than the preform diameter, surface contamination from the chamber surface or preform surface defects are effectively excluded from entering the finished fiber. In this way, our extrusion process for silver halide fiber production shows additional benefits also for core-only or plastic clad/core fiber manufacturing.

Figure 6 illustrates a cross-section of a preform successively deformed of its periphery consisting of a core 74 and a crystalline cladding 75, a layer of polymer lubrication 72 and a protective coating 73 of metal or polymer. This preform is particularly advantageous for the present inventive method. The enhanced quality of the core/cladding boundary in step-index fibers and the improved symmetry in gradient index fibers can also be realized by applying isotropic pressure through gaseous or liquid media. Thus, Figure 8 illustrates a cross section of present system which includes chamber 92, fluid inlet 91, heater 94, die 95, preform 93 and pressurized fluid 91, to produce fiber 96. A lubricant, which could be used to reduce friction, can also serve as the liquid medium. Silicon oil or liquid flouropolymers could be used for this purpose. Argon or other inert gases seem particularly suitable for gas extrusion purposes.

The core/clad preform being subjected to extrusion by a plunger moving in a direction opposite to the fiber flow or to liquid or gas extrusion may also be surrounded by an additional layer of relatively soft metal. This metal layer can then be extruded together with the core/clad (or gradient index) crystalline preform to form a fiber already protected by an external metal sheath against light, stresses or contamination.

The above described types of essentially friction free extrusion substantially suppress lateral surface friction-one of the main causes of macrostructure defects and turbulence intermeshing at the core/cladding boundary.

The present invention is further illustrated by the following examples, but is not limited thereby:

### Example I

A crystal of solid solution of silver halide with a 50/50 ratio of chlorine and bromine, i.e. AgCl_{0.5} : Br_{0.5} was grown with a Hg⁺⁺ dopant (concentration' 0.0003%) by known silver halide crystal growing methods and prepared as an extrusion billet in cylindrical form (15 mm in diameter and 40 mm long). The billet was extruded into a fiber with 1 mm diameter by the present invention friction free process as shown in Figure 3 and described above, i.e. by moving the plunger of 14 mm in diameter in the direction opposite to the fiber flow at about 200°C. The optical losses measured in the fiber by the cut-back method at 10.6 µm were 0.2 dB/m immediately after the extrusion and 0.5 dB/m 1 year later. For comparative purposes a fiber of equal diameter was manufactured at the same temperature from a crystal of AgCl_{0.5} : AgBr_{0.5} solid solution by conventional extrusion in Figure 1 above. Its optical losses were measured as 1 dB/m right after the extrusion and 2.4 dB/m 1 year later. Both fibers were stored in black loose polymer tubes at controlled laboratory conditions to avoid environmental damages.

### Example II

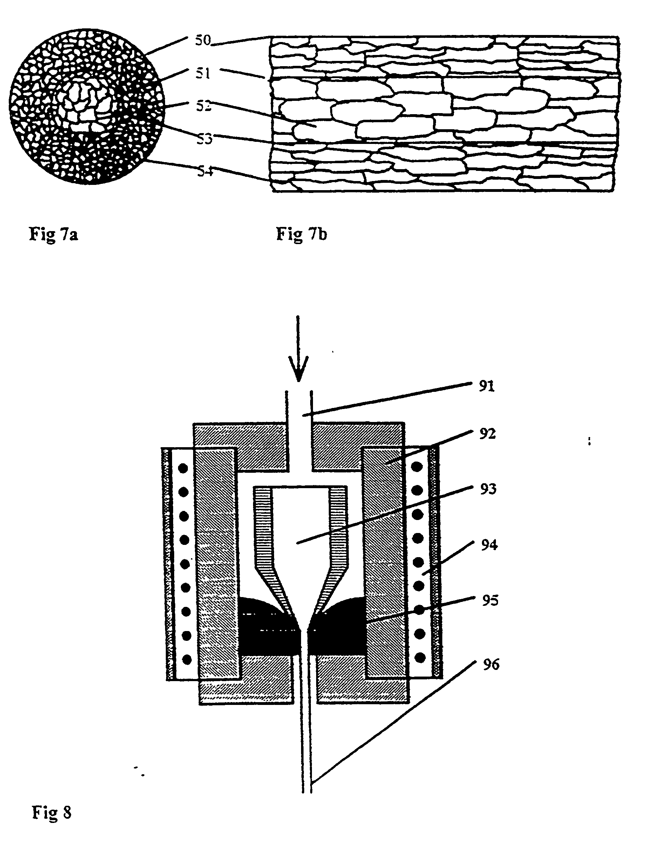

The preform of a structure such as is shown in cross-section in Figure 6. Structure 73 was formed from a AgCl_{0.5} : AgBr_{0.5} core rod (diameter 15 mm), and a AgCl_{0.7} : AgBr_{0.3} cladding tube (15/18 mm diameter), a polyethylene coating tube (18/19 mm diameter) and a OFHC-copper ductile tube (19/20 mm diameter) with a bottom part in a form, suitable for laminar extrusion. Two successive extrusions of this preform through the raw of conical dies were realized with silicon oil as outer lubricant, and the diameters of the orifices were successively decreased from 17 mm to 15 mm. A final friction free extrusion using the Figure 3 method was realized to obtain 1 mm diameter fiber. The optical losses in the fiber were 1.5 dB/m at 10.6 µm. The tensile strength was remarkably high (120 MPa). Structure investigations of chemically etched fiber samples revealed a texture similar to that shown in Figures 7a and 7b, showing a fiber 50 with a core 51 and cladding 54. Note that large, elongated grains 52 are formed toward the center and smaller elongated grains are formed toward and in the cladding, such as grains 53.

It was observed that the fiber could withstand significantly more and several bend cycles than fibers produced directly from non-predeformed crystals described above.

### Example III

A step-index type fiber was produced by the method illustrated in Figure 3 from a predeformed preform (as shown in Figure 5). The extrusion billet (15 mm diameter and 40 mm long) consisted of a single crystalline rod of AgCl_{0.24} : Br_{0.76} solid solution (10 mm diameter and 38 mm long) being inserted in a hollow cylinder cladding of AgCl_{0.5} : Br_{0.5} solid solution (inner diameter 10 mm, outer diameter 15 mm, length 38 mm) and a disk of cladding material was placed at the bottom (diameter 15 mm and 2 mm thickness). The billet was hot extruded (at about 200°C) by friction free extrusion into a fiber of 0.7 mm outside diameter and 0.47 mm core diameter. Good quality of the core-cladding boundary was observed over the length of about 10 m.

Without the insertion of the extra cladding material at the bottom (near the die) much smaller yield was observed due to several meters of start up loss.

## Claims

1. An optical fiber comprising a silver halide solid solution of the formula AgClₓBr₁₋ₓ, wherein x ranges from 0 to 1.0, and one or more dopants selected from the group consisting of AgI and those of the formula MY, wherein M may be Li, Na, K, Rb, Cs; or MY₂, wherein M may be Mg, Ca, Sr, Ba, Cd, Pb or Hg, and Y may be Cl, Br or I, wherein the crystalline grains of the optical fiber are elongated along the fiber axis.

2. The optical fiber according to claim 1, wherein the crystalline grains are larger at the inner core area and decreased in size in the peripheral fiber layers.

3. The optical fiber according to claims 1 and 2, wherein the dopant is AgI and the content of AgI is limited to 5% or less by weight and/or the resultant content of double valent metal cation Mg, Ca, Sr, Ba, Cd, Pb or Hg is limited to 0.001% or less by weight of the fiber.

4. The optical fiber according to any one of the claims 1 to 3, wherein said fiber has a core coated with a polymer having a lower refractive index than said core.

5. The optical fiber according to any one of the claims 1 to 3, wherein said fiber is unclad.

6. The optical fiber according to any one of the claims 1 to 3, wherein said fiber is clad with a lower refractive index silver halide cladding material of the formula AgCl_{z}Br_{1-z}, wherein z is from 0 to 1.0.

## Patentansprüche

1. Eine optische Faser, **dadurch gekennzeichnet, dass** sie einen Silberhalogenid-Mischkristall mit der Summenformel AgClₓBr₁₋ₓ, wobei x sich zwischen 0 und 1,0 bewegt, und eine oder mehrere Dotierungen, ausgewählt aus der Gruppe AgI und denen mit der Formel MY, wobei M Li, Na, K, Rb, Cs sein kann, oder MY₂, wobei M aus Mg, Ca, Sr, Ba, Cd, Pb oder Hg gewählt werden kann, und Y Cl, Br oder I sein kann, beinhaltet, und dass die kristallinen Körner der Faser entlang der Faserachse langgestreckt sind.

2. Eine optische Faser nach Anspruch 1, worin die kristallinen Körner in der inneren Kernregion grösser und in den äusseren Schichten der Faser von verringerter Größe sind.

3. Eine optische Faser nach den Ansprüchen 1 und 2, mit einer AgI-Dotierung, wobei die AgI-Konzentration auf 5% oder weniger des Fasergewichts begrenzt ist und/oder der resultierende Gehalt zweiwertiger Metallkationen Mg, Ca, Sr, Ba, Cd, Pb oder Hg auf 0,001% oder weniger des Gewichtes der Faser beschränkt ist.

4. Eine optische Faser entsprechend einem der Ansprüche 1 bis 3, wobei besagte Faser einen Kern aufweist, der mit einem Polymer ummantelt ist, welches einen niedrigeren Brechungsindex als besagter Kern hat.

5. Eine optische Faser gemäß einem der Ansprüche 1 bis 3, wobei besagte Faser keinen Fasermantel aufweist.

6. Eine optische Faser nach einem der Ansprüche 1 bis 3, wobei besagte Faser mit einem Silberhalogenid-Mantelmaterial der Summenformel AgCl_{z}Br_{1-z}, wobei z zwischen 0 und 1,0 liegt, mit niedrigerem Brechungsindex ummantelt ist.

## Revendications

1. Une fibre optique consistant en une solution solide d'argent hologénure de la formule AgClₓBr₁₋ₓ, où x s'étend de 0 à 1.0, et un ou plusieurs dopants, issus du groupe constitué de AgI et de ceux de la formule MY, où M peut être LI, Na, K, Rb, Cs; ou MY₂, où M peut être Mg, Ca, Sr, Ba, Cd, Pb, ou Hg, et Y peut être CI, Br ou I, où les grains de cristaux de la fibre optique sont étendus le long de l'axe de la fibre.

2. La fibre optique correspondant à la revendication no. 1, où les grains cristaux sont plus gros au niveau de la couche intérieure et diminuent en taille dans les couches périphériques de la fibre.

3. La fibre optique correspondant aux revendications nos. 1 et 2, où le dopant est AgI et la concentration de AgI est limitée à 5 % ou moins du poids et/ou le contenu résultant de cation métallique de double valence Mg, Ca, Sr, Ba, Cd, Pb ou Hg est limité à 0.001 % ou moins du poids de la fibre.

4. La fibre optique correspondant à chacune des revendications 1 à 3, où la fibre en question a un noyau gainé d'un polymère qui a un indice de réfraction inférieur au noyau en question.

5. La fibre optique correspondant à chacune des revendications 1 à 3, où la fibre en question n'est pas gainée.

6. La fibre optique correspondant à chacune des revendications 1 à 3, où la fibre en question est gainée d'un matériel d'argent halogénure de formule AgCl_{z}Br_{1-z}, ayant un indice de réfraction inférieur, où z est de 0 à 1.0.
